(19) Europäisches Patentamt
European Patent Office
Office européen des brevets

(11) **EP 2 979 301 B1**

(12) **FASCICULE DE BREVET EUROPEEN**

(45) Date de publication et mention
de la délivrance du brevet:
**31.05.2017 Bulletin 2017/22**

(21) Numéro de dépôt: **14712658.5**

(22) Date de dépôt: **25.03.2014**

(51) Int Cl.:
*H01L 27/15* (2006.01)    *H01L 31/153* (2006.01)
*H01L 33/16* (2010.01)    *H01L 33/24* (2010.01)
*H01L 33/08* (2010.01)

(86) Numéro de dépôt international:
**PCT/EP2014/055907**

(87) Numéro de publication internationale:
**WO 2014/154657 (02.10.2014 Gazette 2014/40)**

(54) **DISPOSITIF ELECTROLUMINESCENT AVEC CAPTEUR INTEGRE ET PROCEDE DE CONTROLE DE L'EMISSION DU DISPOSITIF**

ELEKTROLUMINESZENTE VORRICHTUNG MIT INTEGRIERTEM SENSOR UND VERFAHREN ZUR STEUERUNG DER EMISSION DER VORRICHTUNG

ELECTROLUMINESCENT DEVICE WITH INTEGRATED SENSOR AND METHOD FOR CONTROLLING THE EMISSION OF THE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.03.2013 FR 1352811**

(43) Date de publication de la demande:
**03.02.2016 Bulletin 2016/05**

(73) Titulaire: **Aledia**
**38040 Grenoble Cedex (FR)**

(72) Inventeurs:
• **CAGLI, Carlo**
  **F-38000 Grenoble (FR)**
• **ANANIA, Giorgio**
  **F-78670 Medan (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
**WO-A2-2012/156620    US-A1- 2010 033 561**
**US-A1- 2012 223 289**

## Description

Le domaine de l'invention est celui des diodes électroluminescentes, couramment désignées par l'acronyme LED (« Light Emitting Diode »).

Un enjeu permanent est d'assurer des performances constantes en terme de luminance pour ce type de dispositifs afin de les fiabiliser et ce au cours du temps notamment.

La présente invention vise ainsi à réduire la variabilité en termes de performance de luminance dans le cas de LED à éléments discrets, pouvant être avantageusement de type nanocolonnes, tels que des nanofils dont les dimensions latérales (diamètre) peuvent par exemple être de l'ordre de quelques centaines de nanomètres et la dimension verticale pouvant aller jusqu'à une dizaine de micromètres, avec un rapport hauteur / diamètre allant de 1 à 30 et typiquement autour de 10.

Au cours de ces dernières années, il a été réalisé par exemple, des diodes électroluminescentes visibles à base de nanofils InGaN/GaN verticaux contenant une jonction p-n et connectés collectivement en parallèle.

Grâce à leurs propriétés intrinsèques potentielles (bonne qualité cristalline, relaxation des contraintes aux surfaces libres verticales, bonne efficacité d'extraction de la lumière ...), les nanofils sont considérés comme des candidats très intéressants pour pallier les difficultés rencontrées actuellement avec des LEDs GaN conventionnelles fabriquées en structure planaire (2D).

Deux approches LEDs Nanofils, basées sur des techniques de croissance différentes, sont connues de l'homme de l'art.

La première filière consiste à épitaxier des nanofils GaN contenant des puits quantiques InGaN en configuration axiale par Epitaxie par Jet Moléculaire (MBE). Les dispositifs fabriqués à partir de ces nanofils ont donné des résultats intéressants dans le domaine spectral vert. Les puces processées de 1 mm$^2$ peuvent émettre autour de 10 $\mu$W à 550 nm pour un courant continu de fonctionnement de 100 mA.

Avec la technique de croissance par jets moléculaires (MBE), certaines inhomogénéités apparaissent en raison de mécanismes de nucléation aléatoire, mais typiquement il a été obtenu une puissance optique sur un fil unique émettant à 550nm de 50nW, soit 5 mW/mm$^2$ avec une centaine de milliers de nanofils émetteurs/mm$^2$.

Plus récemment, la technique de croissance MOCVD (dépôt chimique en phase vapeur à base d'organométalliques) a permis la réalisation de nanofils In-GaN/GaN contenant une structure LED radiale (configuration Coeur/Coquille).

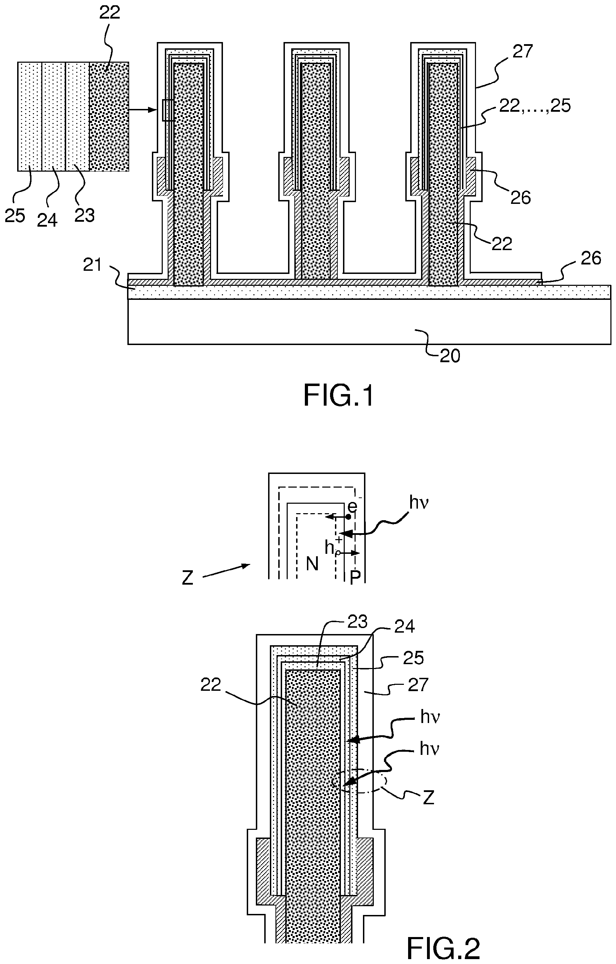

La figure 1 illustre ce type de configuration dans laquelle, des nanofils $NT_n$ sont réalisés à la surface d'un substrat 20 recouvert d'une couche de nucléation 21 permettant de faire l'adaptation de maille entre par exemple un substrat en silicium et des nanofils en GaN.

La structure des nanofils présentant une partie photoconductrice, comportent un coeur 22 en GaN dopé n typiquement avec un taux de dopage de $10^{19}$ cm$^{-3}$, une structure à puits quantiques avec une alternance de couches 23, 24, pouvant respectivement être en GaN non dopée et InGaN, et enfin une couche 25 GaN dopée p avec typiquement un taux de dopage de $10^{19}$ cm$^{-3}$. Une couche diélectrique isolante 26 est prévue afin d'isoler le coeur 22 et le contact supérieur. Les contacts supérieurs sont assurés via une couche supérieure 27 conductrice et transparente à la longueur d'onde d'émission de la structure photoconductrice.

Dans cette approche, la structure LED étant en configuration Coeur/Coquille, la surface de la zone active est plus importante que dans l'approche LEDs nanofils 2D.

Cette propriété apporte deux avantages : l'augmentation de la surface émissive et la diminution des densités de courant dans la zone active. Des structures complètes de LEDs nanofils MOCVD ont été réalisées sur substrat silicium et l'électroluminescence dans le domaine spectral bleu (450nm) a été obtenue sur un ensemble de nanofils intégrés après process technologique.

Grâce aux technologies de croissance de nanofils, la surface d'une puce peut comprendre des centaines de milliers de colonnes sur une surface pouvant typiquement être de 1 mm$^2$.

De telles structures inédites, qui tirent parti des nanotechnologies, offrent l'avantage d'augmenter la surface d'émission et donc le flux lumineux. Le document US2010/033561 A1 décrit un dispositif de microscope à l'état solide comprenant des nanofils émetteur de lumière et des nanofils fonctionnant comme photodétecteurs. Dans ce cadre de LEDs à éléments discrets de très petite taille, typiquement de l'ordre de quelques centaines de nanomètres jusqu'à une dizaine de micromètres, la présente invention propose un dispositif électroluminescent comportant un capteur intégré de type photodiode permettant notamment de réguler la luminance du dispositif et dans lequel il est prévu des moyens pour commander astucieusement la tension de commande des éléments actifs électroluminescents depuis le capteur intégré.

Plus précisément la présente invention a pour objet un dispositif électroluminescent comportant une structure comprenant un ensemble de nanofils à la surface d'un substrat, caractérisé en ce qu'il comprend :

- une première série de nanofils primaires dits d'émission comprenant des nanofils connectés à des premiers contacts électriques et capables d'émettre de la lumière sous l'action d'une première tension dite directe issue d'une source de tension ou de courant dit(e) direct (e) ;
- une seconde série de nanofils secondaires dits de détection voisins desdits nanofils primaires, connectés à des seconds contacts électriques et capables de générer un photo-courant sous l'action d'une lumière ambiante et/ou d'une partie de la lumière émise par une partie desdits nanofils primaires, sous commande d'une seconde tension dite inverse issue d'une source de tension ou de courant ;

- des moyens pour commander ladite tension dite directe en fonction dudit photo-courant.

De manière préférentielle, la seconde tension dite inverse est issue d'une source de tension.

Dans le cas d'une source de courant qui alimente les nanofils primaires, celle-ci génère un courant figé, ce qui se traduit dans une tension a priori variable, pouvant être typiquement autour de 3V. La source d'alimentation des nanofils secondaires par contre reste généralement à tension donnée (typiquement 0V ou inférieure) pour mesurer le courant généré par les nanofils secondaires.

Selon une variante de l'invention, le dispositif comprend des moyens pour injecter ledit photo-courant dans la source de tension ou de courant direct(e) de manière à réguler ladite tension, lesdits moyens comportant un circuit externe à ladite structure et comprenant un comparateur de courant comparant le photocourant $I_{ph}$ généré par les nanofils secondaires à un courant de référence donnée $I_{ref}$ et agissant sur ladite source de tension ou de courant direct(e) pour commander la tension des nanofils primaires.

Selon une variante de l'invention, ladite seconde série de nanofils secondaires dits de détection comprend au moins un sous-ensemble de nanofils de détection capables de générer un photo-courant $I_{ph}$ sous commande d'une tension nulle ou inverse, en présence de lumière ambiante, ledit dispositif comportant un circuit externe à ladite structure et comprenant un comparateur de courant comparant le photocourant généré par les nanofils secondaires à un courant seuil $I_{ph,s}$ de manière à activer via une alimentation équipée d'un interrupteur, ledit dispositif électroluminescent si ladite valeur de photo-courant $I_{ph}$ est inférieure à ladite valeur de courant seuil $I_{ph.s.}$

Selon une variante de l'invention, lesdits nanofils sont recouverts d'une couche conductrice transparente, discontinue entre lesdits nanofils primaires et lesdits nanofils secondaires, de manière à dissocier électriquement un desdits premiers contacts électriques, d'un desdits seconds contacts électriques.

Selon une variante de l'invention, le substrat comprend sur une face arrière définie comme étant opposée à la face comprenant lesdits nanofils, une couche de contact commune à un desdits premiers contacts électriques et à un desdits seconds contacts électriques.

Selon une variante de l'invention, le dispositif comprend des sous-ensembles de nanofils secondaires répartis sur ledit substrat.

Selon une variante de l'invention, le dispositif comprend plusieurs sous-ensembles de nanofils primaires susceptibles d'émettre des photons à des longueurs d'onde différentes $\lambda i_c$, ledit dispositif émettant une lumière composite résultant de la somme des émissions aux différentes longueurs d'onde $\lambda i_c$.

Selon une variante de l'invention, le dispositif comprend plusieurs sous-ensembles de nanofils secondaires, chaque sous-ensemble de nanofils secondaires étant voisin d'un sous-ensemble de nanofils primaires émettant des photons à une longueur d'onde $\lambda i_c$, de manière à pouvoir capter lesdits photons à ladite longueur d'onde $\lambda i_c$.

Selon une variante de l'invention, lesdits nanofils ont des structures à base d'hétérojonction de matériaux III-V.

L'invention a aussi pour objet un procédé de commande d'un dispositif électroluminescent selon l'invention, caractérisé en ce qu'il comprend :

- une étape de détection d'au moins un photo-courant issu d'au moins un sous-ensemble de nanofils secondaires sous l'action d'une lumière ambiante et/ou d'une partie d'une lumière émise par une partie desdits nanofils primaires, sous commande d'une seconde tension dite inverse issue d'une source de tension ou de courant ;
- une étape de commande d'au moins un sous-ensemble de nanofils primaires sous l'action d'une tension dite directe en fonction dudit photo-courant.

L'invention a encore pour objet un procédé de commande d'un dispositif électroluminescent selon l'invention, caractérisé en ce qu'il comprend une étape de commande préalable à ladite étape de détection, d'au moins un sous-ensemble de nanofils primaires dits d'émission, dont l'émission est en partie captée par lesdits nanofils secondaires.

L'invention a aussi pour objet un procédé de contrôle de la luminance d'un dispositif électroluminescent selon l'invention, caractérisé en ce qu'il comprend les étapes suivantes :

- l'application d'une première tension initiale à au moins un sous-ensemble de nanofils primaires ;
- l'application d'une tension inverse à au moins un sous-ensemble des nanofils secondaires de manière à détecter un photo-courant ;
- l'intégration dudit photo-courant dans la détermination d'une tension de commande à appliquer auxdits nanofils primaires de manière à réguler la luminance dudit dispositif.

L'invention a encore pour objet un procédé de contrôle de la répartition de la luminance surfacique d'un dispositif électroluminescent, selon l'invention, caractérisé en ce qu'il comprend :

- l'application d'une première tension initiale à plusieurs sous-ensembles de nanofils primaires ;
- l'application d'une tension inverse à plusieurs sous-ensembles de nanofils secondaires, chaque sous-ensemble de nanofils secondaires étant voisin d'un sous-ensemble de nanofils primaires émettant des photons à une longueur d'onde, lesdits nanofils secondaires étant répartis sur l'ensemble dudit substrat de manière à détecter un photo-courant par sous-ensemble de nanofils secondaires ;
- l'intégration desdits photo-courants dans la détermination d'une tension de commande à appliquer auxdits sous-ensembles de nanofils primaires respectivement associés auxdits sous-ensembles de nanofils secondaires de manière à réguler la répartition surfacique de la luminance dudit dispositif.

L'invention a aussi pour objet un procédé de contrôle de la couleur d'un dispositif électroluminescent selon l'invention émettant une lumière composite résultant de l'émission de plusieurs sous-ensembles de nanofils émettant à des longueurs d'ondes différentes $\lambda i_c$, caractérisé en ce qu'il comprend :

- l'application d'une première tension initiale auxdits sous-ensembles de nanofils primaires ;
- l'application d'une tension inverse à plusieurs sous-ensembles des nanofils secondaires, chaque sous-ensemble de nanofils secondaires étant voisin d'un sous-ensemble de nanofils primaires émettant des photons à une longueur d'onde $\lambda i_c$, de manière à pouvoir capter lesdits photons à ladite longueur d'onde $\lambda i_c$;
- l'intégration desdits photo-courants dans la détermination d'une tension de commande à appliquer auxdits sous-ensembles de nanofils primaires respectivement associés auxdits sous-ensembles de nanofils secondaires de manière à réguler ladite couleur composite dudit dispositif.

L'invention a encore pour objet un procédé de commande d'un dispositif électroluminescent selon l'invention, caractérisé en ce qu'il comprend les étapes suivantes :

- l'application d'une tension inverse à au moins un sous-ensemble de nanofils secondaires de manière à détecter un photo-courant $I_{ph}$ ;
- la comparaison dudit photo-courant à une valeur seuil de courant $I_{ph.s}$ ;
- l'application d'une tension directe aux nanofils primaires de manière à activer ledit dispositif électroluminescent, si ladite valeur de photo-courant $I_{ph}$ est inférieure à ladite valeur de courant seuil $I_{ph.s}$

L'invention sera mieux comprise et d'autres avantages apparaîtront à la lecture de la description qui va suivre donnée à titre non limitatif et grâce aux figures annexées parmi lesquelles :

- la figure 1 illustre une configuration de LED utilisant des nanofils à structure radiale selon l'art connu ;
- la figure 2 illustre le phénomène de capture par des nanofils secondaires de photons émis par des nanofils primaires adjacents auxdits nanofils primaires dans un dispositif de l'invention ;
- la figure 3 illustre une première variante de dispositif de l'invention ;
- les figures 4a (vue en coupe) et 4b (vue de dessus) illustrent un premier exemple de dispositif selon l'invention ;
- la figure 5 illustre un premier exemple de distribution de nanofils primaires et de nanofils secondaires permettant d'amplifier le photo-courant de la partie capteur ;
- la figure 6 illustre une seconde variante de dispositif de l'invention ;
- la figure 7 illustre un second exemple de distribution de nanofils secondaires dans l'ensemble des nanofils d'un dispositif de l'invention permettant d'en réaliser une cartographie de luminance.

De manière générale, le dispositif électroluminescent de l'invention comporte une première série de nanofils primaires destinés à émettre un rayonnement lumineux sous commande électrique, typiquement sous l'action d'une tension de polarisation, désignée ci-après tension directe d'alimentation et une seconde série de nanofils secondaires dits de détection destinés à capter des photons émis par les nanofils primaires et ce pour générer un photo-courant.

Les nanofils à base de matériau semiconducteur comprennent des jonctions de type PN ou préférentiellement de type PIN, soit des régions dopées P, et des régions dopées N, séparées ou non par une région de semiconducteur non dopée dite intrinsèque I. La différence de concentration entre les porteurs des régions P et N provoque la circulation d'un courant de diffusion tendant à égaliser la concentration en porteurs d'une région à l'autre. Les trous de la région P vont diffuser vers la région N laissant derrière eux des atomes ionisés, qui constituent autant de charges négatives fixes. Il en est de même pour les électrons de la région N qui diffusent vers la région P laissant derrière eux des charges positives. Il apparaît aussi au niveau de la jonction une zone contenant des charges fixes positives et négatives. Ces charges créent un champ électrique E et donc une tension interne $V_{int}$ qui s'oppose à la diffusion des porteurs de façon à ce qu'un équilibre électrique s'établisse.

Si on polarise la jonction sous une tension $V_{direct}$, elle réduit la hauteur de barrière qui devient ($V_{int}$ -$V_{direct}$). De nombreux électrons de la région N et de trous de la région P peuvent alors franchir cette barrière de potentiel et, se présentant alors dans un "milieu hostile" (P pour électrons et N pour les trous), ils sont recombinés. Pour rétablir l'équilibre, les trous de la région neutre P se mettent en mouvement vers la zone où se produit la recombinaison (déficit en trous). Les électrons de la région neutre N sont soumis à un phénomène analogue. C'est ce phénomène de recombinaison locale qui explique la circulation du courant direct dans la jonction.

Par ailleurs, lorsqu'une jonction PN ou PIN, polarisée en inverse est exposée à un rayonnement lumineux, celui-ci peut générer un grand nombre de paires électron-trou en faisant passer un électron de la bande de valence à la bande de conduction. Les photo-porteurs libérés dans la région de déplétion et au voisinage direct de celle-ci sont entraînés par le champ électrique de la jonction, ce qui donne lieu à un courant inverse, proportionnel à l'intensité lumineuse incidente appelé courant photo-induit $I_{ph}$.

La figure 2 illustre le phénomène de capture de photons dans un nanofil secondaire, dans le cas de nanofils de structure de type coeur/coquille, mettant en évidence les régions de type N, I et P les phénomènes de transport électron-trou, notés respectivement $e^-$ et $h^+$. La région Z, zone de capture de photons est agrandie.

Le transfert de trous depuis la région N est schématisé, ce transfert étant à l'origine du photo-courant créé par absorption des photons, la région intrinsèquement non-dopée comportant une structure de puits quantiques par exemple telle que celle représentée en figure 1.

Ainsi lorsque le dispositif de l'invention est en fonctionnement, la partie capteur dudit dispositif mesure le photo-courant lié à l'ensemble des photons reçus de la lumière ambiante auxquels s'ajoutent les photons générés par les nanofils primaires commandés électriquement pour générer ces photons.

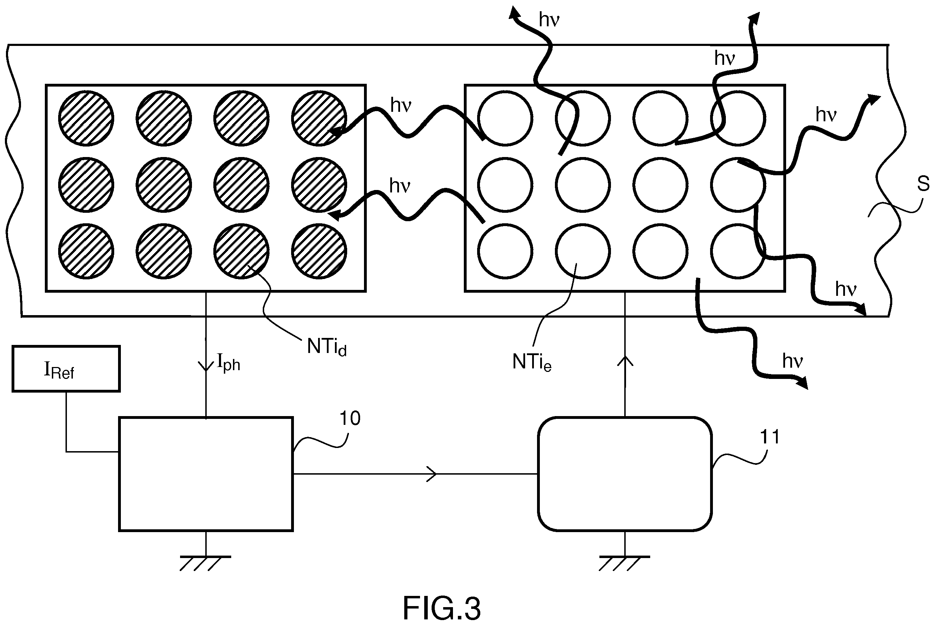

Selon la présente invention, Il est proposé d'exploiter cette détection de photo-courant notamment pour réguler le fonctionnement dudit dispositif en utilisant une boucle de réaction, dans laquelle le courant photo-induit est utilisé pour réguler la tension de commande du dispositif électroluminescent de manière à assurer une puissance lumineuse constante, alors qu'il peut naturellement être soumis à des variations de différentes origines. La figure 3 illustre un tel fonctionnement, avec une structure S comportant la première série de nanofils primaires $NTi_e$ destinés à émettre un rayonnement lumineux sous commande électrique, typiquement sous l'action d'une tension ou courant de polarisation, désignée ci-après tension ou courant direct(e) d'alimentation et la seconde série de nanofils secondaires $NTi_d$ dits de détection destinés à capter une partie des photons émis par les nanofils primaires et ce pour générer un photo-courant. Le photo-courant généré $I_{ph}$ est comparé via un comparateur de courant 10, à un courant de référence $I_{ref}$, afin d'introduire un courant ou une tension donné(e) dans un régulateur d'alimentation 11 des nanofils primaires. Un tel dispositif permet notamment d'assurer des propriétés de luminance régulées, la commande en tension des nanofils primaires pouvant être augmentée ou diminuée selon la puissance d'émission des nanofils primaires d'émission préalablement détectée par une partie au moins des nanofils de détection.

Premier exemple de dispositif électroluminescent :

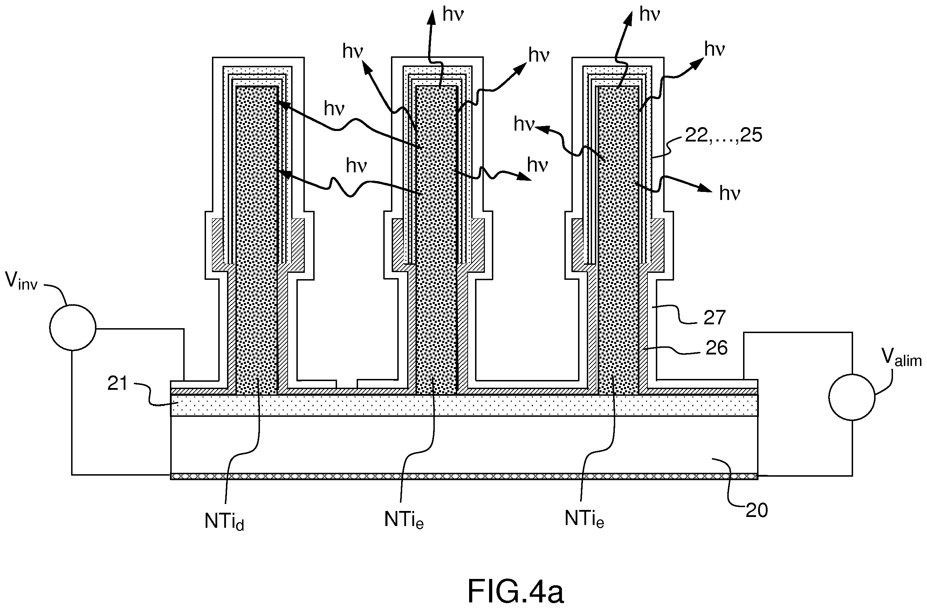

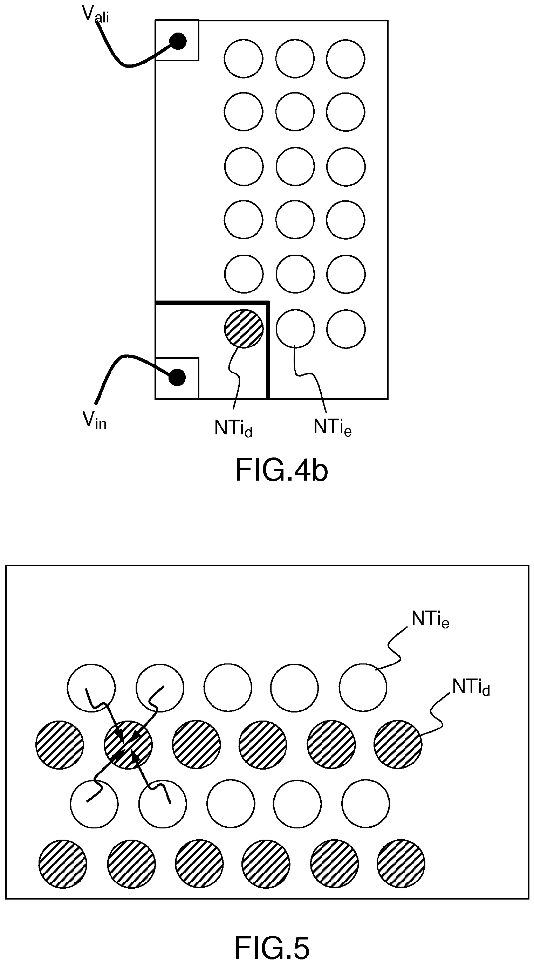

Un premier exemple de dispositif est illustré en figures 4a et 4b. Selon cet exemple, la partie capteur est positionnée en périphérie d'un substrat. Les nanofils présentent des structures de type coeur/coquille à base de GaN , de puits ou multipuits quantiques en InGaN, susceptibles d'émettre dans le bleu à 450 nm, tels que ceux par exemple décrits précédemment et illustrés en figure 1.

Les nanofils primaires d'émission $NTi_e$ sont dissociés électriquement des nanofils secondaires de détection $NTi_d$ par une couche conductrice transparente discontinue 27.

Selon le principe utilisé dans la présente invention, sous l'application d'une tension négative, un nanofil secondaire est soumis au rayonnement généré par ses nanofils primaires voisins, soumis à une tension positive de commande, $V_{alim}$.

Dans le cas de nanofils électroluminescents et capables d'absorber dans le bleu à 450 nm, le Demandeur a considéré qu'à partir de

n = 1,5, n étant l'indice de réfraction du milieu entre les nanofils, et ce en réalisant des simulations, environ 30 % des photons émis par un nanofil primaire voisin, pouvaient traverser ledit nanofil secondaire considéré.

Si on considère une puissance totale émise par puce de l'ordre de 1 $W_{opt}$ (à 450nm), on peut estimer un flux de photons émis par nanofil de $6.10^{12}$ ph / nanofil. sec.

Le coefficient d'absorption d'un puits quantique tel que ceux utilisés dans cet exemple de structure (2nm de InGaN) est par ailleurs de l'ordre $\alpha = 10^5$ cm$^{-1}$, un nanofil présentant une largeur d'environ 2 nm, le rapport d'absorption peut être typiquement de l'ordre de 1%, en considérant l'absorption via la région P négligeable.

Dans le cas d'une distribution de nanofils sur un substrat selon une répartition de type hexagonale, un nanofil central est entouré de 6 nanofils voisins, on obtient alors une puissance totale de capture due à l'émission des nanofils primaires voisins de :

$$6 . 6.10^{12} . 30 \% . 1\% \text{ soit } 10^{11} \text{ ph/sec.}$$

En considérant une collection complète des électrons ainsi générés, le courant susceptible d'être détecté est égal à $10^{11}. 1,6 \ 10^{-19}$ C soit environ 10 nA, soit un courant tout à fait détectable.

Le raisonnement ci-dessus est relatif au courant généré par un seul nanofil secondaire, a fortiori en considérant une centaine de nanofils secondaires, on amplifie en conséquence la valeur du photo-courant susceptible d'être ainsi détecté qui est alors d'environ 1 $\mu$A.

Il peut par exemple être envisagé des distributions linéaires de nanofils primaires et de nanofils secondaires, permettant à un nanofil secondaire d'être voisin de 4 nanofils primaires comme illustré en figure 5, et ce pour des lignées entière de nanofils primaires. Dans cette configuration chaque nanofil secondaire $NTi_d$ est susceptible de recevoir des photons émis pas les 4 nanofils primaires NTi$_e$ voisins.

Selon la présente invention, il est également intéressant de prévoir un mode dans lequel le capteur de type photodiode déclenche lui-même le fonctionnement du dispositif électroluminescent à partir d'un niveau de luminosité ambiant. Dans ce cas, le processus est le suivant :

- on applique une tension inverse aux nanofils secondaires de manière à détecter un photo-courant ;
- si celui-ci est inférieur à une valeur seuil I$_{ph,s}$, on applique une tension directe aux nanofils primaires de manière à activer ledit dispositif électroluminescent.

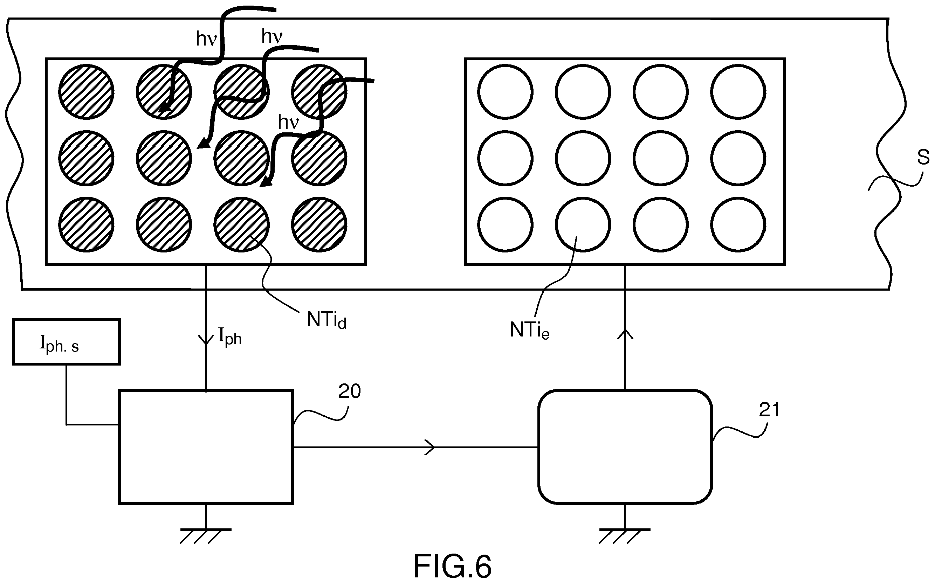

La figure 6 illustre un tel dispositif dans lequel, la structure S comporte des nanofils de détection NTi$_d$ qui détectent des photons provenant de la lumière ambiante et qui génèrent un photo-courant I$_{ph}$, pouvant avantageusement être comparé via un comparateur de courant 20 à un courant seuil I$_{ph,s}$. Si le photo-courant détecté est inférieur à ladite valeur I$_{ph,s}$, cela déclenche l'alimentation de la partie émission constituée par les nanofils primaires émetteurs NTi$_e$ via le bloc d'alimentation 21 équipé d'un interrupteur.

Second exemple de dispositif électroluminescent selon l'invention :

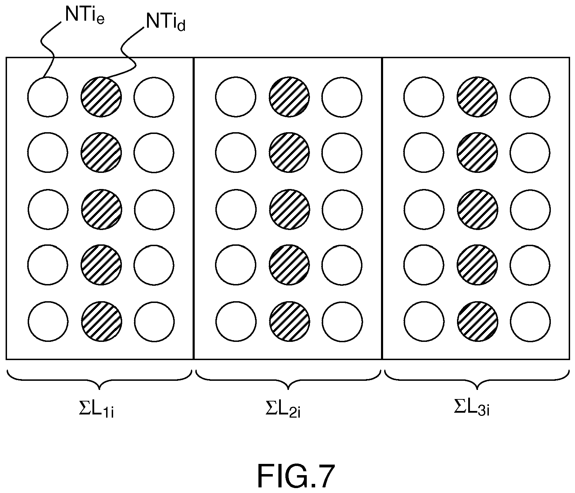

Selon un second exemple de dispositif de l'invention, les nanofils secondaires sont regroupés en sous-ensembles dans différentes régions du dispositif permettant de contrôler la répartition surfacique en luminance L(x,y) dudit dispositif. La figure 7 illustre une telle configuration avec des sous-ensembles de nanofils primaires voisins de sous-ensembles de nanofils secondaires répartis sur l'ensemble du substrat. Plusieurs régions 1, 2 et 3 ont été schématisées montrant les différentes sommations de luminance relatives à des régions données. L'ensemble de ces régions donne des sommes de luminances : $\sum L_{1i}$ (xi, yi) + $\sum L_{2i}$ (xi, yi) +$\sum L_{3i}$ (xi, yi) sur l'exemple schématisé, pouvant être régulées par les photo-courants respectifs détectés. Dans cet exemple les nanofils des régions 1, 2 et 3 peuvent être alimentés de manière indépendante. Les photocourants générés par les sous-ensembles de nanofils secondaires dans les différents secteurs déterminent la tension d'alimentation correcte des nanofils primaires respectifs pour que $\sum L_{1i}$ = $\sum L_{2i}$ =$\sum L_{3i}$.

Troisième exemple de dispositif électroluminescent de type LED émettant une lumière blanche selon l'invention :

Selon un troisième exemple de dispositif de l'invention, il est possible de contrôler la qualité de l'émission d'une lumière composite telle qu'une lumière blanche pouvant être obtenue à partir de composantes RVB (rouge, vert, bleu).

En effet, Il existe actuellement plusieurs technologies permettant d'obtenir des LED émettant une lumière blanche. Un procédé de mise en oeuvre direct consiste à combiner trois LED émettant respectivement dans le rouge, le vert et le bleu. Néanmoins, le pilotage des différentes sources peut s'avérer délicat, dans la mesure où l'on doit mélanger des radiations rouges, vertes et bleues avec des proportions bien précises et de manière reproductible durant la durée de vie de la LED ou quelques soient les conditions environnementales.

Le ou les capteurs de type photodiode intégrés à la LED émettant de la lumière blanche permettent d'atteindre ces objectifs.

On peut ainsi être dans une configuration similaire à celle illustrée en figure 7 avec des sous-ensembles de nanofils primaires émettant dans des longueurs d'onde différentes, respectivement dans le rouge : $\lambda i_R$, le vert : $\lambda i_V$ et le bleu : $\lambda i_B$. Les nanofils secondaires mesurent de manière indépendante les trois composantes RVB, et la tension d'alimentation des nanofils primaires dans les secteurs respectifs est contrôlée pour déterminer une radiation blanche précise et constante dans le temps.

**Revendications**

1. Dispositif électroluminescent comportant une structure comprenant un ensemble de nanofils à la surface d'un substrat, qui comprend :

   - une première série de nanofils primaires dits d'émission (NTi$_e$) comprenant des nanofils connectés à des premiers contacts électriques et capables d'émettre de la lumière sous l'action d'une première tension dite directe issue d'une source de tension ou de courant, dit(e) direct(e) ;
   - une seconde série de nanofils secondaires dits de détection (NTi$_d$) voisins desdits nanofils primaires, connectés à des seconds contacts électriques et capables de générer un photo-courant sous l'action d'une lumière ambiante et/ou d'une partie de la lumière émise par une partie desdits nanofils primaires, sous commande d'une seconde tension, dite inverse issue d'une source de tension ou de courant ;

   **caractérisé en ce qu'**il comprend

   - des moyens pour commander ladite tension dite directe en fonction dudit photo-courant.

2. Dispositif électroluminescent selon la revendication 1, **caractérisé en ce qu'**il comprend des moyens pour injecter ledit photo-courant dans la source de tension ou de courant direct(e) de manière à réguler ladite tension directe, lesdits moyens comportant un circuit externe à ladite structure et comprenant un comparateur de courant (10) comparant le photo-courant généré ($I_{ph}$) par les nanofils secondaires à un courant de référence donnée ($I_{ref}$) et agissant sur un régulateur (11) d'alimentation de ladite source de tension ou de courant direct(e) pour commander la tension des nanofils primaires.

3. Dispositif électroluminescent selon la revendication 1, **caractérisé en ce que** :

    - ladite seconde série de nanofils secondaires dits de détection ($NTi_d$) comprend au moins un sous-ensemble de nanofils de détection capables de générer un photo-courant ($I_{ph}$) sous commande d'une tension nulle ou inverse, en présence de lumière ambiante ;
    - ledit dispositif comportant un circuit externe à ladite structure et comprenant un comparateur de courant (20) comparant le photocourant généré par les nanofils secondaires à un courant seuil ($I_{ph.s}$), de manière à activer via une alimentation (21) équipée d'un interrupteur, ledit dispositif électroluminescent si ladite valeur de photo-courant ($I_{ph}$) est inférieure à ladite valeur de courant seuil ($I_{ph.s}$).

4. Dispositif électroluminescent selon l'une des revendications 1 à 3, **caractérisé en ce que** lesdits nanofils sont recouverts d'une couche conductrice transparente, discontinue entre lesdits nanofils primaires et lesdits nanofils secondaires, de manière à dissocier électriquement un desdits premiers contacts électriques, d'un desdits seconds contacts électriques.

5. Dispositif électroluminescent selon l'une des revendications 1 à 4, **caractérisé en ce que** le substrat comprend sur une face arrière définie comme étant opposée à la face comprenant lesdits nanofils, une couche de contact commune à un desdits premiers contacts électriques et à un desdits seconds contacts électriques.

6. Dispositif électroluminescent selon l'une des revendications 1 à 5, **caractérisé en ce qu'**il comprend des sous-ensembles de nanofils secondaires répartis sur ledit substrat.

7. Dispositif électroluminescent selon l'une des revendications 1 à 6, **caractérisé en ce qu'**il comprend plusieurs sous-ensembles de nanofils primaires susceptibles d'émettre des photons à des longueurs d'onde différentes $\lambda i_c$, ledit dispositif émettant une lumière composite résultant de la somme des émissions aux différentes longueurs d'onde $\lambda i_c$.

8. Dispositif électroluminescent selon la revendication 7, **caractérisé en ce qu'**il comprend plusieurs sous-ensembles de nanofils secondaires, chaque sous-ensemble de nanofils secondaires étant voisin d'un sous-ensemble de nanofils primaires émettant des photons à une longueur d'onde $\lambda i_c$, de manière à pouvoir capter lesdits photons à ladite longueur d'onde $\lambda i_c$.

9. Dispositif électroluminescent selon l'une des revendications 1 à 8, **caractérisé en ce que** lesdits nanofils ont des structures à base d'hétérojonction de matériaux III-V.

10. Procédé de commande d'un dispositif électroluminescent selon l'une des revendications 1 à 9, **caractérisé en ce qu'**il comprend :

    - une étape de détection d'au moins un photo-courant issu d'au moins un sous-ensemble de nanofils secondaires sous l'action d'une lumière ambiante et/ou d'une partie d'une lumière émise par une partie desdits nanofils primaires, sous commande d'une seconde tension dite inverse issue d'une source de tension ou de courant ;
    - une étape de commande d'au moins un sous-ensemble de nanofils primaires sous l'action d'une tension dite directe en fonction dudit photo-courant.

11. Procédé de commande d'un dispositif électroluminescent selon la revendication 10, **caractérisé en ce qu'**il comprend une étape de commande préalable à ladite étape de détection, d'au moins un sous-ensemble de nanofils primaires dits d'émission ($NTi_e$), dont l'émission est en partie captée par lesdits nanofils secondaires.

12. Procédé de contrôle de la luminance d'un dispositif électroluminescent selon l'une des revendications 1-9, **caractérisé en ce qu'**il comprend les étapes suivantes :

    - l'application d'une première tension initiale à au moins un sous-ensemble de nanofils primaires ;
    - l'application d'une tension inverse à au moins un sous-ensemble des nanofils secondaires de manière à détecter un photo-courant ;
    - l'intégration dudit photo-courant dans la détermination d'une tension de commande à appliquer auxdits nanofils primaires de manière à réguler la luminance dudit dispositif.

13. Procédé de contrôle de la répartition de la luminance surfacique d'un dispositif électroluminescent, selon l'une des revendications 1-9, **caractérisé en ce qu'**il comprend :

- l'application d'une première tension initiale à plusieurs sous-ensembles de nanofils primaires ;
- l'application d'une tension inverse à plusieurs sous-ensembles de nanofils secondaires, chaque sous-ensemble de nanofils secondaires étant voisin d'un sous-ensemble de nanofils primaires émettant des photons à une longueur d'onde, lesdits nanofils secondaires étant répartis sur l'ensemble dudit substrat de manière à détecter un photo-courant par sous-ensemble de nanofils secondaires ;
- l'intégration desdits photo-courants dans la détermination d'une tension de commande à appliquer auxdits sous-ensembles de nanofils primaires respectivement associés auxdits sous-ensembles de nanofils secondaires de manière à réguler la répartition surfacique de la luminance dudit dispositif.

14. Procédé de contrôle de la couleur d'un dispositif électroluminescent selon l'une des revendications 7 à 8 émettant une lumière composite résultant de l'émission de plusieurs sous-ensembles de nanofils émettant à des longueurs d'ondes différentes $\lambda i_c$, **caractérisé en ce qu'**il comprend :

- l'application d'une première tension initiale auxdits sous-ensembles de nanofils primaires ;
- l'application d'une tension inverse à plusieurs sous-ensembles des nanofils secondaires, chaque sous-ensemble de nanofils secondaires étant voisin d'un sous-ensemble de nanofils primaires émettant des photons à une longueur d'onde $\lambda i_c$, de manière à pouvoir capter lesdits photons à ladite longueur d'onde $\lambda i_c$ ;
- l'intégration desdits photo-courants dans la détermination d'une tension de commande à appliquer auxdits sous-ensembles de nanofils primaires respectivement associés auxdits sous-ensembles de nanofils secondaires de manière à réguler ladite couleur composite dudit dispositif.

15. Procédé de commande d'un dispositif électroluminescent selon la revendication 10, **caractérisé en ce qu'**il comprend les étapes suivantes :

- l'application d'une tension inverse à au moins un sous-ensemble de nanofils secondaires de manière à détecter un photo-courant ($I_{ph}$) ;
- la comparaison dudit photo-courant à une valeur seuil de courant ($I_{ph.s}$) ;
- l'application d'une tension directe aux nanofils primaires de manière à activer ledit dispositif électroluminescent, si ladite valeur de photo-courant ($I_{ph}$) est inférieure à ladite valeur de courant seuil ($I_{ph.s}$).

**Patentansprüche**

1. Elektrolumineszente Vorrichtung, die eine Struktur umfasst, die einen Satz von Nanodrähten auf der Oberfläche eines Substrats umfasst, die Folgendes umfasst:

- eine erste Serie von primären Nanodrähten, Emissionsnanodrähte ($NTi_e$) genannt, die Nanodrähte umfasst, die mit ersten elektrischen Kontakten verbunden sind und Licht unter der Wirkung einer ersten Spannung, Vorwärtsspannung genannt, emittieren können, die von einer Spannungs- oder Stromquelle, Vorwärtsspannungs- oder Vorwärtsstromquelle genannt, kommt;
- eine zweite Serie von sekundären Nanodrähten, Detektionsnanodrähte ($NTi_d$) genannt, neben den primären Nanodrähten, die mit zweiten elektrischen Kontakten verbunden sind und einen Fotostrom unter der Wirkung eines Umgebungslichts und/oder eines Teils des von einem Teil der primären Nanodrähte ausgesendeten Lichts erzeugen können, gesteuert von einer zweiten Spannung, Umkehrspannung genannt, die von einer Spannungs- oder Stromquelle kommt;

**dadurch gekennzeichnet, dass** sie Folgendes umfasst:

- Mittel zum Regeln der Spannung, Vorwärtsspannung genannt, in Abhängigkeit von dem Fotostrom.

2. Elektrolumineszente Vorrichtung nach Anspruch 1, **dadurch gekennzeichnet, dass** sie Mittel zum Injizieren des Fotostroms in der Vorwärtsspannungs- oder Vorwärtsstromquelle umfasst, um die Vorwärtsspannung zu regeln, wobei die Mittel eine externe Schaltung auf der Struktur und einen Stromkomparator (10) umfassen, der den von den sekundären Nanodrähten erzeugten Fotostrom ($I_{ph}$) mit einem gegebenen Referenzstrom ($I_{ref}$) vergleicht und auf einen Versorgungsregler (11) der Vorwärtsspannungs- oder Vorwärtsstromquelle wirkt, um die Spannung der primären Nanodrähte zu regeln.

3. Elektrolumineszente Vorrichtung nach Anspruch 1, **dadurch gekennzeichnet, dass**:

- die zweite Serie von sekundären Nanodrähten, Detektionsnanodrähte ($NTi_d$) genannt, wenigstens einen Teilsatz von Detektionsnanodrähten umfasst, die einen Fotostrom ($I_{ph}$) unter der Steuerung einer Null- oder Umkehrspannung in Anwesenheit von Umgebungslicht erzeugen können;

- wobei die Vorrichtung eine Schaltung außerhalb der Struktur umfasst und einen Stromkomparator (20) umfasst, der den von den sekundären Nanodrähten erzeugten Fotostrom mit einem Schwellenstrom ($I_{ph.s}$) vergleicht, um über eine mit einem Unterbrecher ausgestattete Versorgung (21) die elektrolumineszente Vorrichtung zu aktivieren, wenn der Wert des Fotostroms ($I_{ph}$) kleiner ist als der Wert des Schwellenstroms ($I_{ph.s}$).

4. Elektrolumineszente Vorrichtung nach einem der Ansprüche 1 bis 3, **dadurch gekennzeichnet, dass** die Nanodrähte von einer transparenten leitenden Schicht bedeckt sind, die zwischen den primären Nanodrähten und den sekundären Nanodrähten unterbrochen ist, um einen der ersten elektrischen Kontakte von einem der zweiten elektrischen Kontakte elektrisch zu trennen.

5. Elektrolumineszente Vorrichtung nach einem der Ansprüche 1 bis 4, **dadurch gekennzeichnet, dass** das Substrat auf einer hinteren Fläche, die als gegenüber der die Nanodrähte umfassenden Fläche liegend definiert ist, eine Kontaktschicht gemeinsam mit einem der ersten elektrischen Kontakte und einem der zweiten elektrischen Kontakte umfasst.

6. Elektrolumineszente Vorrichtung nach einem der Ansprüche 1 bis 5, **dadurch gekennzeichnet, dass** sie Teilsätze von sekundären Nanodrähten aufweist, die auf dem Substrat verteilt sind.

7. Elektrolumineszente Vorrichtung nach einem der Ansprüche 1 bis 6, **dadurch gekennzeichnet, dass** sie mehrere Teilsätze von primären Nanodrähten umfasst, die Photonen von unterschiedlichen Wellenlängen $\lambda i_c$ emittieren können, wobei die Vorrichtung ein zusammengesetztes Licht emittiert, das aus der Summe der Emissionen mit den unterschiedlichen Wellenlängen $\lambda i_c$ resultiert.

8. Elektrolumineszente Vorrichtung nach Anspruch 7, **dadurch gekennzeichnet, dass** sie mehrere Teilsätze von sekundären Nanodrähten umfasst, wobei jeder Teilsatz von sekundären Nanodrähten einem Teilsatz von primären Nanodrähten benachbart ist, die Photonen mit einer Wellenlänge $\lambda i_c$ emittieren, um die Photonen mit der Wellenlänge $\lambda i_c$ erfassen zu können.

9. Elektrolumineszente Vorrichtung nach einem der Ansprüche 1 bis 8, **dadurch gekennzeichnet, dass** die Nanodrähte Strukturen mit Heteroübergangsbasis aus Materialien III-V haben.

10. Verfahren zum Steuern einer elektrolumineszenten Vorrichtung nach einem der Ansprüche 1 bis 9, **da-**

**durch gekennzeichnet, dass** es Folgendes beinhaltet:

- einen Schritt des Erkennens von wenigstens einem Fotostrom von wenigstens einem Teilsatz von sekundären Nanodrähten unter der Wirkung eines Umgebungslichts und/oder eines Teils eines von einem Teil der primären Nanodrähte emittierten Lichts, gesteuert mit einer zweiten Spannung, Umkehrspannung genannt, von einer Spannungs- oder Stromquelle;
- einen Schritt des Steuerns von wenigstens einem Teilsatz von primären Nanodrähten unter der Wirkung einer Spannung, Vorwärtsspannung genannt, in Abhängigkeit von dem Fotostrom.

11. Verfahren zum Steuern einer elektrolumineszenten Vorrichtung nach Anspruch 10, **dadurch gekennzeichnet, dass** es vor dem Erkennungsschritt einen Steuerschritt von wenigstens einem Teilsatz von primären Nanodrähten, Emissionsnanodrähte ($NTi_e$) genannt, beinhaltet, deren Emission teilweise von den sekundären Nanodrähten erfasst wird.

12. Verfahren zum Regeln der Luminanz einer elektrolumineszenten Vorrichtung nach einem der Ansprüche 1-9, **dadurch gekennzeichnet, dass** es die folgenden Schritte beinhaltet:

- Anlegen einer ersten Anfangsspannung an wenigstens einen Teilsatz von primären Nanodrähten;
- Anlegen einer Umkehrspannung an wenigstens einen Teilsatz von sekundären Nanodrähten, um einen Fotostrom zu erkennen;
- Integrieren des Fotostroms in die Bestimmung einer Steuerspannung, die an die primären Nanodrähte anzulegen ist, um die Luminanz der Vorrichtung zu regeln.

13. Verfahren zum Regeln der Verteilung der Oberflächenluminanz einer elektrolumineszenten Vorrichtung nach einem der Ansprüche 1-9, **dadurch gekennzeichnet, dass** es Folgendes beinhaltet:

- Anlegen einer ersten Anfangsspannung an mehrere Teilsätze von primären Nanodrähten;
- Anlegen einer Umkehrspannung an mehrere Teilsätze von sekundären Nanodrähten, wobei jeder Teilsatz von sekundären Nanodrähten einem Teilsatz von primären Nanodrähten benachbart ist, die Photonen mit einer Wellenlänge emittieren, wobei die sekundären Nanodrähte auf dem Satz des Substrats so verteilt sind, dass ein Fotostrom pro Teilsatz von sekundären Nanodrähten erkannt wird;
- Integrieren der Fotoströme in die Bestimmung einer Steuerspannung, die an die Teilsätze von primären Nanodrähten anzulegen ist, die jeweils mit den Teilsätzen von sekundären Nanodrähten assoziiert sind, um die Oberflächenverteilung der Luminanz der Vorrichtung zu regeln.

14. Verfahren zum Regeln der Farbe einer elektrolumineszenten Vorrichtung nach einem der Ansprüche 7 bis 8, die ein zusammengesetztes Licht emittiert, das aus der Emission von mehreren Teilsätzen von Nanodrähten resultiert, die mit unterschiedlichen Wellenlängen $\lambda i_c$ emittieren, **dadurch gekennzeichnet, dass** es Folgendes beinhaltet:

- Anlegen einer ersten Anfangsspannung an die Teilsätze von primären Nanodrähten;
- Anlegen einer Umkehrspannung an mehrere Teilsätze von sekundären Nanodrähten, wobei jeder Teilsatz von sekundären Nanodrähten einem Teilsatz von primären Nanodrähten benachbart ist, die Photonen mit einer Wellenlänge $\lambda i_c$ emittieren, damit die Photonen mit der Wellenlänge $\lambda i_c$ erfasst werden können;
- Integrieren der Fotoströme in die Bestimmung einer Steuerspannung, die an die Teilsätze von primären Nanodrähten anzulegen ist, die jeweils mit den Teilsätzen von sekundären Nanodrähten assoziiert sind, um die zusammengesetzte Farbe der Vorrichtung zu regeln.

15. Verfahren zum Steuern einer elektrolumineszenten Vorrichtung nach Anspruch 10, **dadurch gekennzeichnet, dass** es die folgenden Schritte beinhaltet:

- Anlegen einer Umkehrspannung an wenigstens einen Teilsatz von sekundären Nanodrähten, um einen Fotostrom ($I_{ph}$) zu erkennen;
- Vergleichen des Fotostroms mit einem Stromschwellenwert ($I_{ph.s}$);
- Anlegen einer Vorwärtsspannung an die primären Nanodrähte, um die elektrolumineszente Vorrichtung zu aktivieren, wenn der Wert des Fotostroms ($I_{ph}$) kleiner ist als der Wert des Schwellenstroms ($I_{ph.s}$).

## Claims

1. An electroluminescent device including a structure comprising a set of nanowires on the surface of a substrate which comprises:

- a first series of primary so-called emission nanowires ($NTi_e$) comprising nanowires connected to first electrical contacts and capable of emitting light under the action of a first so-called forward voltage from a so-called forward voltage or forward current source;

- a second series of secondary so-called detection nanowires ($NTi_d$) adjacent to said primary nanowires, connected to second electrical contacts and capable of generating a photocurrent under the action of an ambient light and/or of a portion of the light emitted by some of said primary nanowires, under the control of a second so-called reverse voltage from a voltage or current source;

**characterised in that** it comprises:

- means for controlling said so-called forward voltage as a function of said photocurrent.

2. The electroluminescent device according to claim 1, **characterised in that** it comprises means for injecting said photocurrent into the forward voltage or forward current source so as to regulate said forward voltage, said means comprising a circuit external to said structure and comprising a current comparator (10) comparing the photocurrent generated ($I_{ph}$) by the secondary nanowires to a given reference current ($I_{ref}$) and acting on a power supply regulator (11) of said forward voltage or forward current source to control the voltage of the primary nanowires.

3. The electroluminescent device according to claim 1, **characterised in that**:

- said second series of secondary so-called detection nanowires ($NTi_d$) comprises at least one subset of detection nanowires capable of generating a photocurrent ($I_{ph}$) under the control of a zero or reverse voltage, in the presence of ambient light;
- said device comprising a circuit external to said structure and comprising a current comparator (20) comparing the photocurrent generated by the secondary nanowires to a threshold current ($I_{ph.s}$), so as to activate, via a power supply (21) equipped with a switch, said electroluminescent device if said photocurrent value ($I_{ph}$) is less than said threshold current value ($I_{ph.s}$).

4. The electroluminescent device according to any of claims 1 to 3, **characterised in that** said nanowires are covered by a transparent conductive layer, discontinuous between said primary nanowires and said secondary nanowires, so as to electrically disassociate one of said first electrical contacts from one of said second electrical contacts.

5. The electroluminescent device according to any of claims 1 to 4, **characterised in that** the substrate comprises, on a rear face defined as being opposite the face comprising said nanowires, a contact layer common to one of said first electrical contacts and to one of said second electrical contacts.

6. The electroluminescent device according to any of claims 1 to 5, **characterised in that** it comprises subsets of secondary nanowires distributed over said substrate.

7. The electroluminescent device according to any of claims 1 to 6, **characterised in that** it comprises a plurality of subsets of primary nanowires which may emit photons at different wavelengths $\lambda i_c$, said device emitting a composite light resulting from the sum of the emissions at the different wavelengths $\lambda i_c$.

8. The electroluminescent device according to claim 7, **characterised in that** it comprises a plurality of subsets of secondary nanowires, each subset of secondary nanowires being adjacent to a subset of primary nanowires emitting photons at a wavelength $\lambda i_c$, so as to be able to capture said photons at said wavelength $\lambda i_c$.

9. The electroluminescent device according to any of claims 1 to 8, **characterised in that** said nanowires have structures based on heterojunction of III-V materials.

10. A method for controlling an electroluminescent device according to any of claims 1 to 9, **characterised in that** it comprises:

    - a step of detection of at least one photocurrent from at least one subset of secondary nanowires under the action of an ambient light and/or of a portion of a light emitted by some of said primary nanowires, under the control of a second so-called reverse voltage from a voltage or current source;
    - a step of controlling at least one subset of primary nanowires under the action of a so-called forward voltage as a function of said photocurrent.

11. The method for controlling an electroluminescent device according to claim 10, **characterised in that** it comprises a step of controlling, prior to said detection step, at least one subset of primary so-called emission nanowires ($NTi_e$), the emission of which is partly captured by said secondary nanowires.

12. A method for regulating the luminance of an electroluminescent device according to any of claims 1-9, **characterised in that** it comprises the following steps:

    - the application of a first initial voltage to at least one subset of primary nanowires;
    - the application of a reverse voltage to at least one subset of the secondary nanowires so as to detect a photocurrent;
    - the integration of said photocurrent in the determination of a control voltage to be applied to said primary nanowires so as to regulate the luminance of said device.

13. A method for regulating the distribution of the surface luminance of an electroluminescent device, according to any of claims 1-9, **characterised in that** it comprises:

    - the application of a first initial voltage to a plurality of subsets of primary nanowires;
    - the application of a reverse voltage to a plurality of subsets of secondary nanowires, each subset of secondary nanowires being adjacent to a subset of primary nanowires emitting photons at a wavelength, said secondary nanowires being distributed over all of said substrate so as to detect a photocurrent per subset of secondary nanowires;
    - the integration of said photocurrents in the determination of a control voltage to be applied to said subsets of primary nanowires respectively associated with said subsets of secondary nanowires so as to regulate the surface distribution of the luminance of said device.

14. A method for regulating the colour of an electroluminescent device according to either of claims 7 to 8 emitting a composite light resulting from the emission of a plurality of subsets of nanowires emitting at different wavelengths $\lambda i_c$, **characterised in that** it comprises:

    - the application of a first initial voltage to said subsets of primary nanowires;
    - the application of a reverse voltage to a plurality of subsets of secondary nanowires, each subset of secondary nanowires being adjacent to a subset of primary nanowires emitting photons at a wavelength $\lambda i_c$, so as to be able to capture said photons at said wavelength $\lambda i_c$;
    - the integration of said photocurrents in the determination of a control voltage to be applied to said subsets of primary nanowires respectively associated with said subsets of secondary nanowires so as to regulate said composite colour of said device.

15. A method for controlling an electroluminescent device according to claim 10, **characterised in that** it comprises the following steps:

    - the application of a reverse voltage to at least one subset of secondary nanowires so as to detect a photocurrent ($I_{ph}$);

- the comparison of said photocurrent to a current threshold value ($I_{ph.s}$);
- the application of a forward voltage to the primary nanowires so as to activate said electroluminescent device, if said photocurrent value ($I_{ph}$) is less than said threshold current value ($I_{ph.s}$).

## FIG.1

## FIG.2

FIG.3

FIG.4a

EP 2 979 301 B1

FIG.4b

FIG.5

FIG.6

FIG.7

**EP 2 979 301 B1**

## RÉFÉRENCES CITÉES DANS LA DESCRIPTION

**Documents brevets cités dans la description**

- US 2010033561 A1